# EUROPEAN PATENT APPLICATION

(11) **EP 1 705 664 A2**
(43) Date of publication of application: **27.09.2006**
(21) Application number: 06004752.9
(22) Date of filing: 08.03.2006
(51) Int. Cl.: G11C 7/16, G06F 3/023

(54) **Multi-function remote controller**

(30) Priority: 10.03.2005 EP 05005310
(71) Applicant: TOPSEED TECHNOLOGY CORP., Chung Ho City, Taipei Hsien, Taiwan 235 (CN)
(72) Inventor: Chen, Shoei-Lai, Chung Ho City Taipei Hsien Taiwan 235 (CN)
(74) Representative: TER MEER - STEINMEISTER & PARTNER GbR

(57) **Abstract**

A multi-function remote controller includes a main body (1) and a receiver (2) within the remote controller. The main body (1) includes a USB connection port (14) for connecting to a USB connector (21). The receiver (2) includes memory for storing digital data such as digital audio data. The main body (1) of the remote controller has playback ability of digital audio data. Therefore, the main body (1) of the remote controller can be used as standalone digital audio data player or thumb drive.

## Description

### 1. Field of the Invention

The present invention relates to a remote controller, especially to a remote controller with main body built in with USB connection port electrically connected to a receiver.

### 2. Description of Prior Art

The consumer electronic product and electronic storage media have rapid progress recently as the advance of electronic technology and prevailing of computer system. More particularly, people gradually use notebook computer and projector for presentation and lecture. The presentation material of notebook computer is projected to screen or whiteboard by the projector for view by the audience.

When the presentation is to be changed to next or previous page, the lecturer generally needs to approach the computer and press page-up or page-down key. The frequent key pressing operation on the computer will interrupt the presentation.

Therefore, a remote controller is developed to control the page switching for computer. The remote controller includes a receiver therein, and a USB connector arranged at front face thereof and pluggable to a USB port of a notebook computer. When a speaker wants to control the screen content, he can operate the remote controller to send a control signal. In this way, the page of presentation can be changed or cursor can be moved. However, the prior art /receiver can only perform signal transmission/reception function and no further function is available. It is desirable to provide a function integration of remote controller and flash memory/thumb drive.

### SUMMARY OF THE INVENTION

The present invention is intended to integrate playback function of digital audio data to a remote controller.

Accordingly, the present invention provides a multi-function remote controller, the remote controller includes:
a main body comprising an accommodation space therein and containing a first chamber for containing a battery and a second chamber therein, a USB connection port being arranged in the second chamber and electrically connected to a control circuit in the main body, a cover plate being placed atop the accommodation space; the main body includes a plurality of keys on a front face and an earphone jack and a set of control keys on a lateral face thereof;
a receiver (2) assembled in the second chamber (13) and comprising a USB connector (21) arranged at front end thereof and connectable to the USB connection port (14), the USB connector (21) being electrically connected to a memory in the receiver and the memory being used for storing digital data.

### BRIEF DESCRIPTION OF DRAWING:

The features of the invention believed to be novel are set forth with particularity in the appended claims. The invention itself however may be best understood by reference to the following detailed description of the invention, which describes certain exemplary embodiments of the invention, taken in conjunction with the accompanying drawings in which:
Fig. 1 shows an exploded view of the present invention.
Fig. 2 shows a perspective view of the remote controller and the receiver.
Fig. 3 shows the perspective view of the present invention.
Fig. 4 shows a schematic view of showing application of the remote controller.

### DETAILED DESCRIPTION OF THE INVENTION

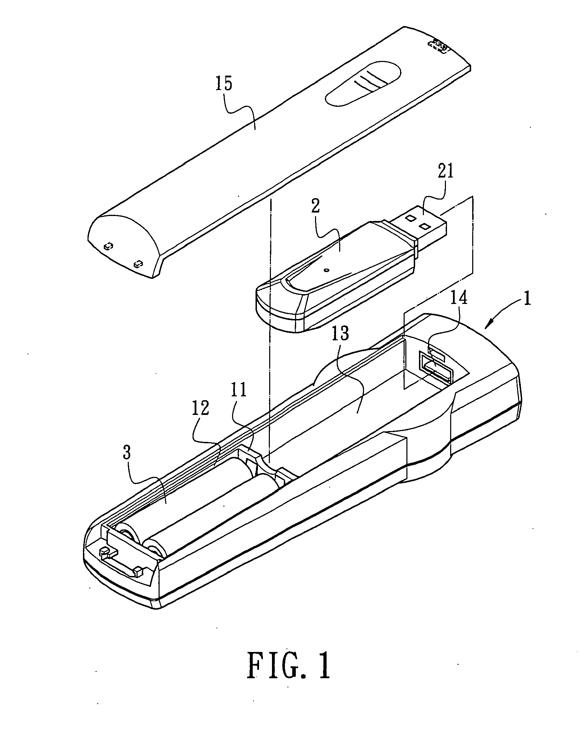

Fig. 1 shows an exploded view of the present invention. The multi-function remote controller of the present invention includes a main body 1 and a receiver 2 in the main body 1.

The main body 1 includes an accommodation space 11 and the accommodation space 11 includes a first chamber 12 and a second chamber 13. The first chamber 12 is used to place battery 3 for supplying working power. A USB connection port 14 is placed in the second chamber 13. The USB connection port 14 is electrically connected to a control circuit (not shown) in the main body 1. A cover plate 15 is arranged atop the accommodation space 11.

The receiver 2 includes a USB connector 21 at front face thereof. The USB connector 21 is electrically connected to a signal-receiving circuit (not shown) therein and the USB connection port 14. A memory is provided for the receiver circuit for digital storage such as digital audio file.

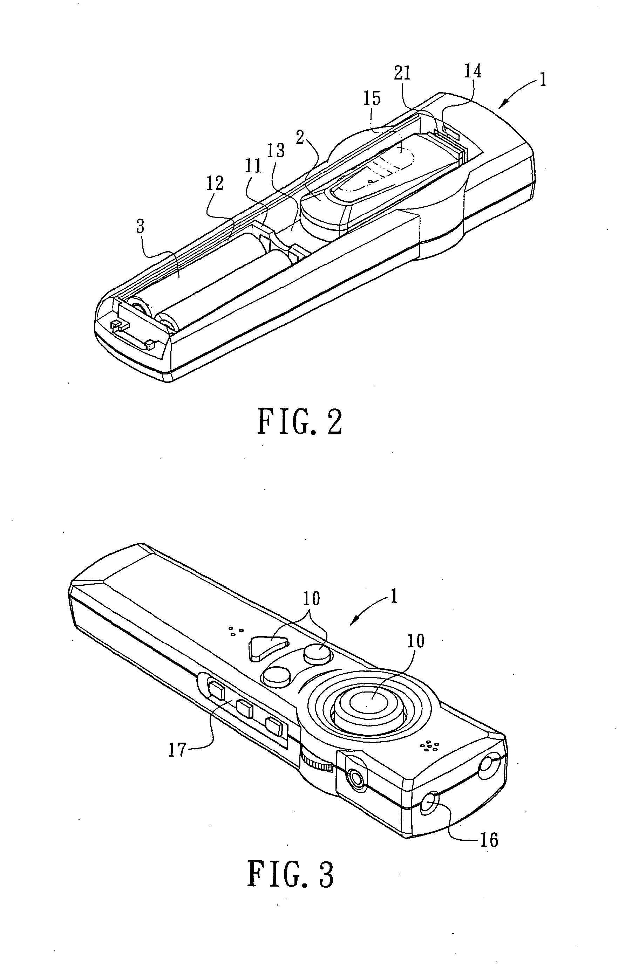

Fig. 2 shows a perspective view of the remote controller and the receiver, where the cover plate 15 is removed from the main body 1. The battery 3 is assembled in the first chamber 12 and the receiver 2 is placed in the second chamber 13. The receiver 2 is pushed forward such that the USB connector 21 at front face of the receiver 2 is in contact with the USB connection port 14. Afterward, the cover plate 15 is covered on the accommodation space 11. Therefore, the receiver 2 will not move in the second chamber 13 or detach with the USB connection port 1 when the main body 1 is carried out.

Fig. 3 shows the perspective view of the present invention. The main body 1 includes a plurality of operation keys 10 on front face there and used for page change and cursor movement. The main body 1 further includes an earphone jack 16 and a set of control keys 17 on lateral face thereof. The receiver 2 is placed in the second chamber 13 and is electrically connected to the USB connection port 14 through the USB connector 21. The control keys 17 are pressed such that the digital audio data in the memory of the receiver 2 is sent to the main body 1 through the USB connector 21 and the USB connection port 14. The control circuit in the main body 1 has playback ability to play the digital audio data. At this time, user can insert an earphone plug to the earphone jack 16 to listen to the playback music.

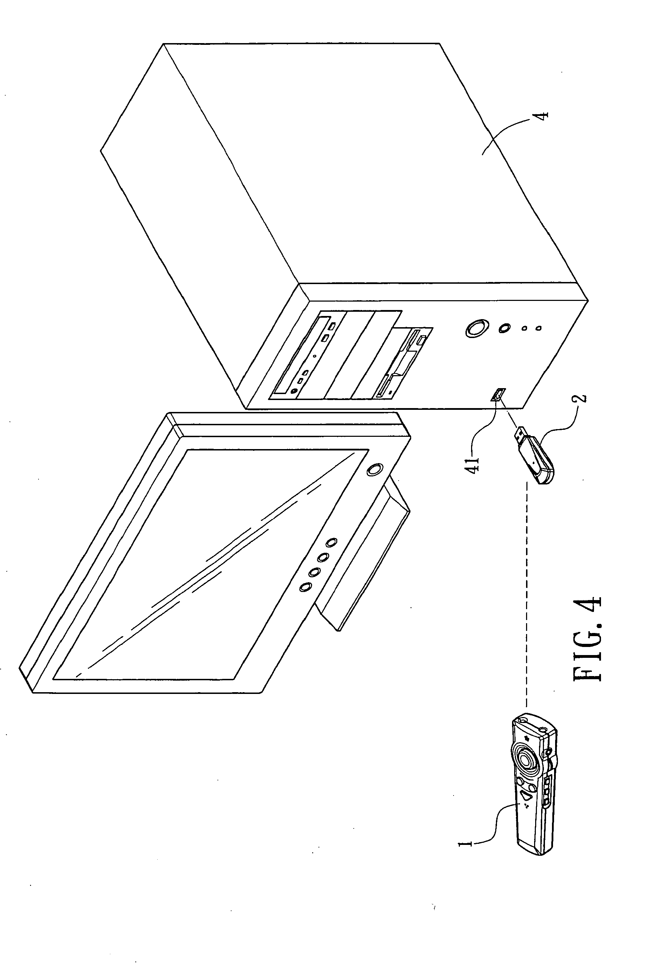

Fig. 4 shows a schematic view of showing application of the remote controller. When the USB connector 21 of the receiver 2 is connected to a USB connection port 41 of a host computer 4, the screen page can be switched and the cursor can be moved by operating the operation keys 10 on front face of the main body 1.

Moreover, when the receiver 2 is not operated at signal reception mode, the receiver 2 can download digital audio file from the host computer 4. The digital audio file is stored in the memory in the receiver 2 through the USB connection port 41 and the USB connector 21.

Although the present invention has been described with reference to the preferred embodiment thereof, it will be understood that the invention is not limited to the details thereof. Various substitutions and modifications have suggested in the foregoing description, and other will occur to those of ordinary skill in the art. Therefore, all such substitutions and modifications are intended to be embraced within the scope of the invention as defined in the appended claims.

## Claims

1. A multi-function remote controller, comprising:
a main body (1) comprising an accommodation space (11) therein and containing a first chamber (12) and a second chamber (13) therein, a USB connection port (14) being arranged in the second chamber (13), a cover plate (15) being placed atop the accommodation space (11);
a receiver (2) assembled in the second chamber (13) and comprising a USB connector (21) arranged at front end thereof and connectable to the USB connection port (14), the USB connector (21) being electrically connected to a memory in the receiver and the memory being used for storing digital data.

2. The multi-function remote controller as in claim 1, wherein the main body (1) comprises a plurality of keys (10) at front face thereof.

3. The multi-function remote controller as in claim 1, wherein the main body (1) comprises an earphone jack (16) and a set of control keys (17) at lateral face thereof.

4. The multi-function remote controller as in claim 1, wherein the first chamber (12) is used to receive a battery (3).

5. The multi-function remote controller as in claim 1, wherein the USB connection port (14) is electrically connected to a control circuit in the receiver.

6. The multi-function remote controller as in claim 5, wherein the control circuit has playback function for digital audio data.

7. The multi-function remote controller as in claim 1, wherein the digital data is digital audio data.

8. The multi-function remote controller as in claim 1, wherein the receiver comprises a signal-receiving circuit electrically connected to a memory.
